# EUROPEAN PATENT APPLICATION

(11) **EP 3 573 344 A1**
(43) Date of publication of application: **27.11.2019**
(21) Application number: 18173848.5
(22) Date of filing: 23.05.2018
(51) Int. Cl.: H04R 1/04, B81B 7/00

(54) **SENSOR ARRANGEMENT AND METHOD TO OPERATE A SENSOR ARRANGEMENT**

(71) Applicant: AMS Sensors UK Limited, Cambridge, Cambridgeshire CB4 0DL (GB)
(72) Inventor: Maccioni, Alberto, 19123 La Spezia (IT); Besling, Willem Frederik Adrianus, 5615 JN Eindhoven (NL)
(74) Representative: Epping - Hermann - Fischer

(57) **Abstract**

The invention relates to a sensor arrangement (1) comprising a microphone (17), a sensor element (7), a controllable current source configured to provide an adjustable current and a control circuit. The control circuit is configured to operate the sensor (7) by switching it between a number of states and, based on the state of the sensor (7), either increase or decrease the adjustable current between a lower value and an upper value by means of respective predefined ramps.

## Description

The present disclosure relates to a sensor arrangement having a sensor and a microphone and a method to operate such a sensor arrangement.

Sensor arrangements with multiple sensors in a single package are commonly utilized in applications in which space for components is limited. Prominent examples of such applications are portable devices such as mobile phones. Due to the increasing number of sensors being employed in these devices, space for additional components is becoming more and more limited.

In addition to space limitations, energy consumption is an important figure of merit, in particular for portable devices which usually rely on batteries with only limited capacity.

An object to be achieved is to provide an improved concept for an energy saving sensor arrangement having an ambient sensor and a microphone.

This object is achieved with the subject-matter of the independent claims. Embodiments and developments of the improved concept are defined in the dependent claims.

The improved concept is based on the idea of not permanently powering the ambient sensor, but to power it only in case a measurement is intended. However, solely switching the sensor on and off on demand causes an unwanted crosstalk between the sensor and the microphone.

PCT/EP2017/064630 relates to a microphone and pressure sensor package with an integrated pressure sensor on CMOS technology. Optional additional sensors, such as temperature sensors may be included in the package as well.

To isolate the arrangement from unwanted external forces and to ensure the functioning of the microphone, the sensor arrangement is preferably entirely integrated in an enclosed package with only one opening to the environment, as also realized in the reference above. The microphone as well as the ambient sensor are consequently able to detect changes in an ambient gas, such as pressure, via equilibrating of gas inside the sensor package through the opening.

When powering the ambient sensor in a periodic manner, however, thermo-acoustical noise can arise, in particular in packages confining small volumes. This thermo-acoustical noise is caused by sudden temperature changes induced by Ohmic heating of electrical components when switching on or off currents for supplying the ambient sensor. The Ohmic heating in turn induces thermal heating and therefore thermal expansion of the ambient gas surrounding the sensor and the microphone. As the microphone is configured to detect soundwaves, i.e. fast pressure variations, this thermal expansion is subsequently detected, causing an unwanted crosstalk between the sensor and the microphone in the form of an acoustic signal if the thermo-acoustical noise comprises components in the audio band.

To eradicate this noise, a sensor arrangement according to the improved concept comprises, besides a microphone and the ambient sensor, in addition a controllable current source which is configured to provide an adjustable current. The sensor arrangement according to the improved concept further comprises a control circuit which is configured to switch the sensor between a number of states and, based on the state of the sensor, either increase or decrease the adjustable current between a lower value and an upper value by means of respective predefined ramps.

It is the purpose of the control circuit, in combination with the controllable current source, to prevent the occurrence of thermo-acoustical noise. To this end, while operating the sensor with a duty cycle in order to significantly reduce the overall power consumption compared to continuous operation, the aforementioned components are configured to eliminate the rapid heating and cooling of the sensor. This is achieved by means of the control circuit which increases both the rise and decay time of the overall power consumption with the aim that the thermal expansion of the ambient gas occurs on timescales long enough to be outside the audio band, i.e. the sensitivity range of the microphone. In particular, the control circuit ramps the total power consumption of the ambient sensor in a controlled way by means of an adjustable current from the controllable current source.

The improved concept further comprises a method for operating a sensor in such a sensor arrangement.

In various embodiments of the sensor arrangement according to the improved concept, the control circuit is configured to perform a sequence. The sequence comprises a first phase, in which the control circuit switches the sensor from a disabled state to an idle state and increases the adjustable current from the lower value to the upper value by means of a first predefined ramp. The first phase of the sequence is followed by a second phase, in which the control circuit decreases the adjustable current to the lower value, switches the sensor to a sensing state, waits for a duration of a sensing time, switches the sensor to the idle state and increases the adjustable current to the upper value. The sensing time may be predefined. Finally, in a third phase of the sequence the control circuit decreases the adjustable current from the upper value to the lower value by means of a second predefined ramp and switches the sensor to the disabled state.

While the microphone generally is continuously powered, the sequence described above allows for a significant reduction of the overall consumed power by powering the sensor periodically, for example whenever a measurement is desired. Typical measurement rates are in the order of 1 Hz, wherein the actual measurement or sensing time of the sensor is in the order of 20 ms. The low ratio of sensing time to measurement period means a large potential for saving of energy. Instead of instantaneous switching of the sensor between the disabled and the sensing state causing thermo-acoustical noise as explained above, the first and the third phase of the above-mentioned sequence provide low enough ramps to avoid an undesired crosstalk between the sensor and the microphone. Typical ramp-up and ramp-down times are in the order of 1 ms to 20 ms, leading to the duration of the entire sequence of 60 ms or less.

The second phase constitutes the actual sensing phase, in which the control circuit switches the ramped up current from the upper value back to the lower value and enables the sensing state of the sensor, such that the level of the overall power consumption remains constant. In order to ensure a constant overall power consumption, the switching of the ramped up current and the enabling of the sensing state may occur with a time delay with respect to each other. This time delay may be positive or negative, depending on rise and fall times of the adjustable current and the current of the sensor. For example, a positive time delay may signify a delayed enabling of the sensing state of the sensor after switching of the ramped up current to the lower value, while a negative time delay may signify an overlap between the two processes, i.e. a switching of the sensor to its sensing state before switching the ramped up current to the lower value.

After the sensing time before the end of the second phase, the inverted procedure is applied in order to switch back from the enabled sensor to the adjustable current, again while maintaining a constant overall power consumption, before entering the third phase. In this last phase of the sequence, the adjustable current is ramped down by means of the second predefined ramp.

In at least one embodiment, the lower value corresponds to no current being output by the controllable current source.

In at least one embodiment, the upper value corresponds to the difference between the current consumed by the sensor in a sensing state and the current consumed by the sensor in an idle state.

The ramping of the adjustable current between the lower and the upper value aims to ensure that there is no sudden increase or decrease of the power consumption throughout the entire sequence. This in turn prevents any sudden thermal expansion of the ambient gas due to heating, hence suppressing the occurrence of thermo-acoustical noise. In particular, the overall power consumption at any point of the sequence is given by the sum of the power consumption of the sensor in its respective state, e.g. the idle state during the first and the second phase, and the adjustable current generated by means of the controllable current source. Therefore, the ramp according to the described embodiments ramps the overall current between the current levels in the idle and in the sensing state of the sensor. Typical ambient sensors require currents of approximately 100 nA in the disabled state, between 6 µA and 35 µA in the idle state and between 65 µA and 75 µA in the sensing state.

In at least one embodiment, the control circuit is configured to, based on the state of the sensor, either increase or decrease the adjustable current gradually.

A gradual increase of the adjustable current can be realized, for example, by means of a counter in the control circuit controlling the current source. The predefined ramps in these embodiments consist of step functions that partition the interval between the lower and the upper value into steps, preferably steps that are equal in terms of temporal length and rise.

In at least one embodiment, the predefined ramps consist of a predefined number of steps.

To achieve an acceptable trade-off between low overall power consumption and slow enough ramping of the current to prevent thermo-acoustical noise, the ramps typically consist of about eight steps, each of which is around 2 ms long and has a rise of approximately 5 µA.

In at least one embodiment, the circuit is configured to operate the sensor in a pulsed mode. For instance, the sensor may be operated in a pulsed fashion, in particular with a given measurement rate.

In some cases, a periodic measurement of a certain parameter of the ambient gas, e.g. pressure, is desired. To achieve a corresponding measurement rate, for example a rate of 1 Hz, the control circuit may be configured to automatically operate the sensor according to the improved concept at the desired rate, for example once every second.

In at least one embodiment, the sensor is a capacitive sensor.

The power consumption of the sensor during sensing is an important parameter for the overall power consumption also in pulsed operation. As for pressure sensors, for example, capacitive sensors require a significantly lower current in the sensing state compared to piezo-resistive devices. In addition, operating at a lower current also means shorter ramp times as the rise of the ramp determines the rate of Ohmic heating. Again owing to their lower power consumption, this constitutes a second advantage of capacitive sensors over piezo-resistive devices. A third advantage of capacitive sensors is the fact that the total dissipated power of a capacitive sensor is generally lower than for a piezo-resistive sensor, which has a positive impact on the magnitude of the thermo-acoustical signal.

In at least one embodiment, the ambient sensor is either a pressure sensor, a temperature sensor, a gas sensor, a humidity sensor or an ultrasound sensor.

All of the above-mentioned sensor types can be conveniently combined with a microphone in a single sensor package. All of them are configured to measure a parameter of the ambient gas, which can enter the package through the one opening for the microphone.

In at least one embodiment, the sensor and the microphone are arranged in a CMOS configuration. In particular, they may be arranged in a CMOS application specific integrated circuit, ASIC.

Especially for the application in mobile devices, a small footprint is of high importance. A CMOS compatible ASIC configuration reduces the form factor of the sensor arrangement while maintaining a large enough volume inside the package both to improve the signal-to-noise ratio of the microphone, in particular a MEMS microphone, and to reduce the impact of Ohmic heating on the gas inside the package.

In at least one embodiment, the sensor arrangement is monolithic.

Integrating the microphone, the sensor and the control circuit on a single substrate further reduces both the die area as well as fabrication costs.

The aforementioned object is further solved by a method of operating a sensor arrangement, for example according to one of the embodiments described above. The method comprises a switching of a sensor of the sensor arrangement between a number of states. The method further comprises, based on the state of the sensor, either increasing or decreasing an adjustable current between a lower value and an upper value by means of respective predefined ramps.

Further embodiments of the method become apparent to the skilled reader from the embodiments of the sensor arrangement described above.

The following description of figures of exemplary embodiments may further illustrate and explain aspects of the improved concept. Elements and parts of the arrangement with the same structure and the same effect, respectively, appear with equivalent reference symbols. Insofar as elements and parts of the arrangement correspond to one another in terms of their function in different figures, the description thereof is not repeated for each of the following figures.
- Figure 1: shows a cross-section of an exemplary sensor arrangement according to the improved concept;
- Figure 2: shows a scheme of an exemplary control circuit according to the improved concept; and
- Figure 3: shows an exemplary timing diagram of the operation of a sensor arrangement according to the improved concept.

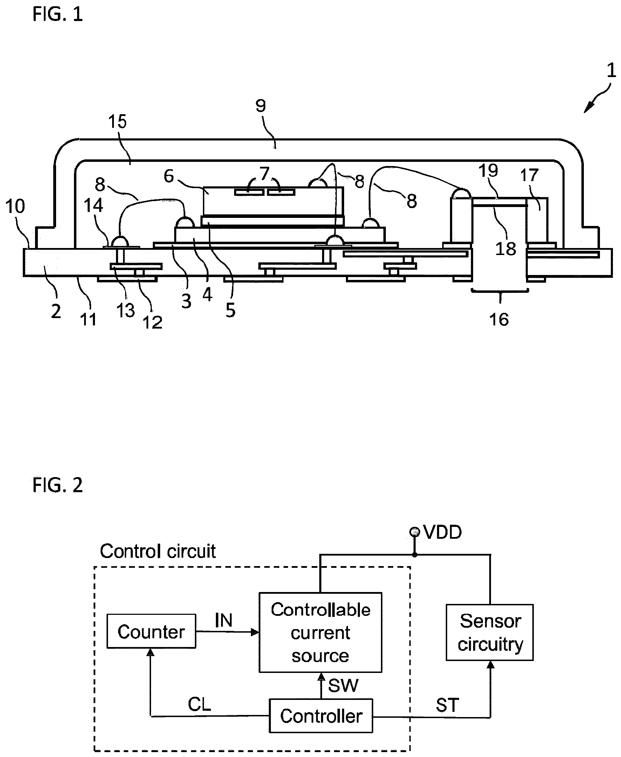

Figure 1 shows a cross-section of a sensor arrangement 1. The sensor arrangement 1 comprises a carrier 2 with an opening 16 and optional integrated electric conductors 13, shield plates and/or passives. An optional stack includes a bond layer 3 on a top surface 10 of the carrier 2 as well as a bottom device 4 on the bond layer 3. An adhesive layer 5 is applied on the bottom device 4. The adhesive layer 5 may instead be applied directly on the top surface 10 of the carrier 2. An ASIC device 6 with an integrated sensor element 7, or array of sensor elements 7, is arranged on the adhesive layer 5. A microphone device 17 comprising a diaphragm 18 and a back plate 19 is arranged above the opening 16. Electric connections 8, for example bond wires, are provided between the ASIC device 6 and contact pads 14 on the top surface 10 of the carrier 2 and between the ASIC device 6 and the microphone device 17. A cover 9 is applied on the top surface 10, so that a cavity 15 is formed between the carrier 2 and the cover 9. The ASIC device 6 and the microphone device 17 are accommodated in the cavity 15. Terminal contacts 12 for external electric connections may be formed on the rear surface 11 of the carrier 2, opposite the top surface 10.

The carrier 2 may for example be a printed circuit board. The terminal contacts 12 in combination with the integrated electric conductors 13 acting as a wiring provide electrical access to the sensor arrangement 1 for connecting the ASIC device 6 to a power supply, for instance.

The bottom device 4 may comprise semiconductor material, which may in particular be silicon. The bottom device 4 can especially be used for mechanical decoupling of the ASIC device 6 from the carrier 2. In this case, the bottom device 4 may be an insulator or glass material or a semiconductor material. The mechanical decoupling of the ASIC device 6 from the bottom device 4 may be achieved by selecting an appropriate material, for instance silicone, as well as an appropriate thickness for the adhesive layer 5.

The ASIC device 6 may be a CMOS device, for instance. The ASIC device 6 may comprise an evaluation circuit which is configured for the read-out of the sensor element 7 but may also comprise a control circuit according to the improved concept for operating the sensor element 7. The ASIC device 6 may also comprise a further evaluation circuit configured for the read-out of the microphone device 17. The sensor element 7 may be any conventional ambient sensor or array of ambient sensors, which may be realized, for instance, as a microelectromechanical, MEMS, system. The ambient sensor may be a capacitive or piezo-resistive type of sensor, in particular a pressure sensor, a temperature sensor, a gas sensor, a humidity sensor or an ultrasound sensor.

The microphone device 17 may be a MEMS system, for instance. The microphone device 17 comprises a membrane or diaphragm 18, which through the opening 16 is exposed to an ambient medium, for example ambient air. Pressure variations such as sound waves generate corresponding vibrations of the diaphragm 18. The back plate 19 may provide a mechanical support of the microphone device 17 and may be electrically conductive. If the diaphragm 18 is electrically conductive as well, the back plate 19 can be used as an electrode for a measurement of the capacitance between the diaphragm 18 and the back plate 19. The capacitance varies according to the vibrations of the diaphragm 18. Consequently, the variations of the capacitance can be evaluated to compute the frequency of the vibrations, for example by means of an evaluation circuit in the ASIC device 6.

The cover 9 may comprise a metal lid. Microphone packages generally require a certain back volume that is completely sealed from the environment. Therefore the cover 9 may hermetically seal the cavity 15. The diaphragm 18 comprises at least one small opening, for example a hole, for equilibrating the gas between the cavity 15 and the environment. The hole is preferably small enough to maintain the function and sensitivity of the microphone 17.

The exemplary sensor arrangement 1 shown in figure 1 is a specific example of a sensor arrangement 1 according to the improved concept. A fundamental sensor arrangement 1 that achieves the object comprises a microphone 17 and a sensor element 7, preferably in an enclosed package comprising a lid 9 and an opening 16. For achieving the object, the sensor arrangement 1 at least further comprises a controllable current source and a control circuit, that may be included in the ASIC device 6.

Figure 2 shows a scheme illustrating an exemplary control circuit according to the improved concept. The control circuit may comprise a controllable current source, a controller and a counter.

The controllable current source, for instance an N-bit current source, in such a control circuit is configured to generate a current proportional to an input signal IN. The current source may further be configured to disable or enable the generated current based on a switch signal SW.

The counter, for instance an N-bit counter, may be configured to generate the input signal IN and provide it to the controllable current source. In particular, the input signal IN may be proportional to an integer count comprised by the counter.

The controller of the control circuit is configured to ramp up or ramp down the adjustable current generated by the current source. To this end, the controller either increases or decreases the count of the counter by means of a clock signal CL, therefore influencing a magnitude of the input signal IN correspondingly. The controller further may generate the switch signal SW and provide it to the controllable current source in order to switch between an enabled and a disabled state of the generated adjustable current. The controller may further be configured to switch the state of the sensor element 7 and its circuitry, for example by means of a state signal ST. The circuitry of the sensor element 7 may for example comprise the evaluation circuit configured for the read-out of the sensor element 7. The controller may in particular be configured to switch the sensor element 7 between a disabled state, an idle state and a sensing state.

The control circuit may be integrated in the ASIC device 6 and connected to a power supply, for example a battery, via the contact terminals 12 on the rear surface 11 of the carrier 2.

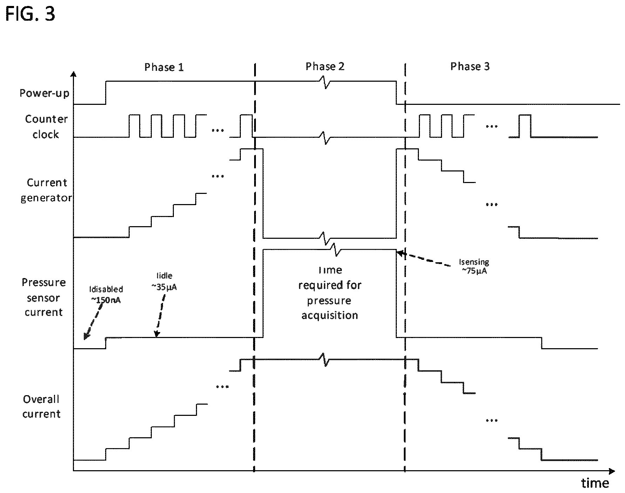

Figure 3 shows a timing diagram illustrating the intended operation of a sensor element 7, for example a pressure sensor, by means of the control circuit according to the improved concept, for instance the control circuit shown in figure 2. Preferably, the operation of the sensor element 7 is defined by a routine which comprises three phases.

A power-up signal initiates the routine of the control circuit by starting the first phase. The power-up signal can for example be generated by means of the host device of the sensor arrangement 1 in order to initiate a measurement of the sensor element 7. Following the power-up signal, in the first phase the control circuit switches the sensor element 7 from the disabled state to the idle state, resulting in an idle current supplied to the sensor element 7. Typically, the idle current is between 6 µA and 35 µA.

Subsequently, the controller of the control circuit provides a first clock signal CL, for example comprising a predefined number of pulses, to the counter to increase the count. The counter generates an input signal IN proportional to the count and provides this input signal IN to the controllable current source. The current source generates an adjustable current proportional to the input signal IN, and hence the count, resulting in a gradual ramp from a lower value to an upper value, with the ramp comprising a number of discrete steps corresponding to the number of pulses of the first clock signal CL.

Preferably, during the first phase the adjustable current is gradually increased from 0 A to the upper value, such that at the end of the ramp-up the overall current, defined by the sum of the idle current of the sensor element 7 and the adjustable current, corresponds to the operating current required by the sensor element 7 in the sensing state. This operating current is typically between 65 µA and 75 µA for capacitive pressure sensors.

Piezo-resistive devices require a significantly higher operating current, typically an order of magnitude larger. To achieve an acceptable trade-off between consumed power and slow enough ramping, each step typically takes 2 ms and increases the adjustable current by 5-10 µA, such that around eight steps are required to reach the upper value.

The end of the first phase marks the beginning of the second phase. At the beginning of the second phase, the controller first disables the adjustable current from the current source and switches the sensor element 7 into the sensing state. With switching the sensor element 7 into the sensing state, the current required by the sensor shows a sudden increase of the required current. In order to compensate for this sudden increase, i.e. maintaining the level of the overall current, the switching of the sensor element 7 and the disabling of the adjustable current must coincide.

In contrast to the illustrated case, the switching of the sensor element 7 may result in a ramp-up of its required operating current. In this case, the disabling of the adjustable current likewise has to proceed with a corresponding inverted ramp.

The sensor element 7 now stays in the sensing state for a predefined time. During this time, an evaluation circuit may read out the sensor element 7, in particular it may read out a pressure sensitive quantity of the sensor element 7, in case the sensor element 7 is a pressure sensor. Typically, the predefined length required for the acquisition is in the order of 10 ms to 100 ms.

After this time, the controller first switches the sensor element 7 back into the idle state before the adjustable current from the current source is enabled at the upper value, again maintaining the overall current during this procedure and finalizing the second phase.

The third phase is analogous to the first phase with the difference that the adjustable current in this third phase is to be ramped down to the lower value instead of being ramped up. To this end, the controller now decreases the count of the counter by means of a second clock signal CL, resulting in a decreasing input signal IN and therefore a decreasing adjustable current from the current source. As for the first phase, the ramping likewise proceeds within about 8 steps of 2 ms each, ramping the adjustable current down to preferably 0 A. Following the last step, the idle current is switched off by switching the sensor element 7 to the disabled state through the controller. In its disabled state, the sensor element 7 and its circuitry typically require a current of about 150 nA.

In some cases, the power profile of the sensor element 7 can be more complex than described above. For instance, the currents in the respective states may be non-constant. In these cases, the adjustable current can be matched by means of a matched power profile, for instance.

As the measurement phase of this procedure takes about 10 ms to 100 ms and the programmable up and down ramps each take typically about 20 ms, the entire process takes about 50 ms to 140 ms. Waiting times in between the measurements can be programmed e.g. with increments of 10 ms up to 60000 ms. Therefore a measurement rate of up to about 16 Hz can be realized with reduced current consumption. Typical measurement rates for ambient sensors are, however, in the order of 1 Hz.

The procedure described in figure 3 aims at eliminating thermo-acoustical noise, as described above. With slow enough ramping of an adjustable current, sudden increases and decreases of currents are suppressed, resulting in the prevention of, due to heating or cooling of the ASIC device 6 comprising the sensor element 7, rapid thermal heating or cooling of gas confined in the cavity 15. As the cavity 15 is enclosed with the exception of the opening 16 in the carrier 2, rapid thermal heating or cooling would cause a corresponding thermal expansion of the gas inside the cavity, resulting in sudden pressure changes that may be consequently picked up by means of the microphone device 17.

The control circuit depicted in figure 2 and the operation principle illustrated in figure 3 constitute a specific example for achieving the object of the invention. A fundamental requirement of operating a sensor arrangement 1 according to the improved concept is to provide an adjustable current by means of a controllable current source. Moreover, the control circuit is required to switch the sensor element 7 of the sensor arrangement 1 between a number of states and, based on the state of the sensor element 7, to either increase or decrease the adjustable current between a lower value and an upper value by means of respective predefined ramps.

### Reference numerals

- 1: sensor arrangement
- 2: carrier
- 3: bond layer
- 4: bottom device
- 5: adhesive layer
- 6: ASIC device
- 7: sensor element
- 8: electric connection
- 9: lid
- 10: top surface
- 11: rear surface
- 12: contact terminal
- 13: integrated electric conductor
- 14: contact pad
- 15: cavity
- 16: opening
- 17: microphone device
- 18: diaphragm
- 19: back plate
- CL: clock signal
- IN: input signal
- ST: state signal
- SW: switch signal

## Claims

1. A sensor arrangement (1) comprising
- a microphone (17), in particular a MEMS microphone (17);
- a sensor (7);
- a controllable current source configured to provide an adjustable current; and
- a control circuit configured to
- switch the sensor (7) between a number of states; and
- based on the state of the sensor (7) either increase or decrease the adjustable current between a lower value and an upper value by means of respective predefined ramps.

2. The sensor arrangement (1) according to claim 1, wherein the control circuit is configured to perform a sequence, the sequence comprising
- a first phase in which the control circuit switches the sensor (7) from a disabled state to an idle state and increases the adjustable current from the lower value to the upper value by means of a first predefined ramp;
- a second phase in which the control circuit decreases the adjustable current to the lower value, switches the sensor (7) to a sensing state, waits for a duration of a sensing time, switches the sensor (7) to the idle state and increases the adjustable current to the upper value; and
- a third phase in which the control circuit decreases the adjustable current from the upper value to the lower value by means of a second predefined ramp and switches the sensor (7) to the disabled state.

3. The sensor arrangement (1) according to claim 1 or 2, wherein the lower value corresponds to no adjustable current being provided by the controllable current source.

4. The sensor arrangement (1) according to one of claims 1 to 3, wherein the upper value corresponds to a difference between a current consumed by the sensor (7) in a sensing state and a current consumed by the sensor (7) in an idle state.

5. The sensor arrangement (1) according to one of claims 1 to 4, wherein the control circuit is configured to, based on the state of the sensor (7), either increase or decrease the adjustable current gradually.

6. The sensor arrangement (1) according to one of claims 1 to 5, wherein the predefined ramp consists of a predefined number of steps.

7. The sensor arrangement (1) according to one of claims 1 to 6, wherein the circuit is further configured to operate the sensor (7) in a pulsed mode.

8. The sensor arrangement (1) according to one of claims 1 to 7, wherein the sensor (7) is one of the following: a pressure sensor, a temperature sensor, a gas sensor, a humidity sensor or an ultrasound sensor.

9. The sensor arrangement (1) according to one of claims 1 to 8, wherein the sensor (7) is a capacitive sensor.

10. The sensor arrangement (1) according to one of claims 1 to 9, wherein the electrical circuit, the sensor (7) and the microphone (17) are arranged in a CMOS configuration, in particular in a CMOS application-specific integrated circuit, ASIC.

11. The sensor arrangement (1) according to one of claims 1 to 10, wherein the microphone (17) and the sensor (7) are arranged in a single package, in particular in an enclosed package having an opening.

12. The sensor arrangement (1) according to one of claims 1 to 11, wherein the sensor arrangement (1) is monolithic.

13. A method to operate a sensor arrangement (1) having a sensor (7), a microphone (17) and a controllable current source, the method comprising
- switching the sensor (7) between a number of states; and
- based on the state of the sensor (7) either increase or decrease an adjustable current between a lower value and an upper value by means respective predefined ramps.

14. The method according to claim 13, further comprising a sequence, the sequence comprising
- a first phase in which the sensor (7) is switched from a disabled state to an idle state and the adjustable current is increased from the lower value to the upper value by means of a first predefined ramp;
- a second phase in which the adjustable current is decreased to the lower value, the sensor (7) is switched to a sensing state, the sensor (7) is switched to the idle state after a predefined sensing time and the adjustable current is increased to the upper value; and
- a third phase in which the adjustable current is decreased from the upper value to the lower value by means of a second predefined ramp and the sensor (7) is switched to the disabled state.

15. The method according to claim 13 or 14, wherein the sensor (7) is operated in a pulsed mode.
